# EUROPÄISCHE PATENTSCHRIFT

(11) **EP 3 538 905 B1**
(45) Veröffentlichungstag und Bekanntmachung des Hinweises auf die Patenterteilung: **22.02.2023**
(21) Anmeldenummer: 17808781.3
(22) Anmeldetag: 07.11.2017
(51) Int. Cl.: G01R 31/08, H04B 3/54

(54) **VERFAHREN, ANORDNUNG UND COMPUTERPROGRAMMPRODUKT FÜR EINE ZUSTANDSÜBERWACHUNG VON ELEKTRISCHEN LEITUNGEN**
METHOD, ARRANGEMENT, AND COMPUTER PROGRAM PRODUCT FOR MONITORING THE STATE OF ELECTRICAL LINES
PROCÉDÉ, AGENCEMENT ET PRODUIT PROGRAMME D'ORDINATEUR POUR LA SURVEILLANCE DE L'ÉTAT DE CÂBLES ÉLECTRIQUES

(30) Priorität: 11.11.2016 DE 102016222208
(43) Veröffentlichungstag der Anmeldung: 18.09.2019
(73) Patentinhaber: Siemens Aktiengesellschaft, 80333 München (DE)
(72) Erfinder: BAUSCH, Jörg, 90587 Tuchenbach (DE)
(86) Internationale Anmeldenummer: PCT/EP2017/078402
(87) Internationale Veröffentlichungsnummer: WO 2018/087058

(56) Entgegenhaltungen:
- EP-A2- 2 608 417
- US-A1- 2004 036 478
- US-A1- 2007 179 721

## Beschreibung

Die Erfindung betrifft ein Verfahren für eine Zustandsüberwachung von elektrischen Leitungen gemäß dem Oberbegriff des Anspruchs 1, eine Anordnung nach Anspruch 11 sowie ein Computerprogrammprodukt nach Anspruch 12.

Ein solches Verfahren ist bereits aus der EP 2 608 417 A2 bekannt. Ähnliche Verfahren zeigen die US 2004/036478 A1 und die US 2007/179721 A1.

Beim Betrieb von Betriebsmitteln wie elektrischen Freileitungen können durch den Alterungszustand des Kabels, Witterungseinflüsse wie Temperatur und Eisbedeckung sowie Wind, und durch innere Einflüsse wie aktueller Strombelastung, Widerstand, Durchhang und Teilentladungen unterschiedlichste Betriebszustände ausgebildet werden. Diese Betriebszustände sind für die jeweils aktuell zur Verfügung stehende maximale elektrische Übertragungskapazität ausschlaggebend.

Betriebsmittel sind beispielsweise Schaltanlagen in luft- oder gasisolierter Technologie, Kabel, gasisolierte Leitungen, etc. Technisch relevante Betriebszustände sind z.B.:
- Niveaus und Charakteristika von Teilentladungen (TE) als Indikator für die Isolationsfähigkeit und die elektrische Festigkeit von Betriebsmitteln, und
- Windlasten und das dadurch verursachte Schwingen von Freileitungen, und
- Durchhang und Betriebsmitteltemperatur von Freileitungen.

Der technische Zustand in Bezug auf Isolationsfähigkeit bzw. Übertragungskapazität wird heute teilweise bereits durch den Einsatz geeigneter Sensorik ermittelt.

Im Stand der Technik sind zur Bestimmung von Teilentladungen Systeme von Qualitrol aus der Produktbroschüre "Solution Overview - Asset Condition Monitoring, Extend operational life and reduce downtime", Seiten 6 und 7, Kennnummer CA-X00-01L-02E, bekannt. Eine Bestimmung des Betriebszustands von Kabeln erfolgt über eigens dafür konzipierte Sensoren mittels softwarebasierter Auswertung des Niveaus und der Charakteristik von Teilentladungen.

Zur Bestimmung von Wind- und Eislasten auf Freileitungen werden meist keine Bestimmungen oder Messungen vorgenommen. Diese Einwirkungen werden durch eine entsprechende Dimensionierung der Betriebsmittel bereits in der Planungsphase berücksichtigt und als statisch angesehen (z.B. in der "Freileitungsnorm EN 50 341, Grundlagen der Bemessung und Lastannahmen" von Hr. Kießling, Abschnitt 4, sind hierzu normative Vorgaben zu finden). Die Bestimmung von Eislasten erfolgt im Bedarfsfall visuell durch vor-Ort-Inspektionen. Bekannt ist dazu die Veröffentlichung "Freileitungsnorm EN 50341, Bemessung und Nachweis der elektrischen Abstände für Freileitungen" von van Dyk et al.

Die Ermittlung des Durchhangs einer Freileitung wird häufig indirekt durch Berechnungen mit vorliegenden Betriebs- und Umweltparametern durchgeführt. Dazu ist beispielsweise die Veröffentlichung "Seiltemperatur und Durchhang von Freileitungen berechnen", Bulletin SEV/AES 13/2008, bekannt.

Neuerdings gibt es spezielle Sensoren (so genannte "e-Grains"), die auf die Freileitung aufgebracht werden, und mit geeigneten Sensoren die Temperatur, den Lagewinkel und die Feldstärke messen und diese Daten durch drahtlose Kommunikation zur Auswertung an eine geeignete Auswerteeinheit weitergeben. Diese Sensoren sind aus der Internet-Publikation "EGRAINS: REVOLUTION AUF DEN STROMLEITUNGEN" der RWE, bekannt. Auch das Fraunhofer Institut würdigt diese Technologie unter http://www.izm.fraunhofer.de/de/news_events/tech_news/reserve n-im-stromnetz-aufspueren.html. Allen genannten Verfahren ist gemein, dass zusätzliche Verfahren und/oder Einrichtungen notwendig sind, um den Betriebszustand der Übertragungsleitungen zu ermitteln.

An die Erfindung stellt sich die Aufgabe, ein Verfahren für eine Zustandsüberwachung von elektrischen Leitungen anzugeben, das besonders einfach und kostengünstig eingesetzt werden kann.

Die Erfindung löst diese Aufgabe durch ein Verfahren gemäß Anspruch 1.

Es wird davon ausgegangen, dass viele Energieversorgungsleitungen bereits über digitale Kommunikationseinrichtungen, insbesondere so genannte "powerline communication" (PLC) Systeme verfügen, welche die Leitungen als Übertragungsmedium zur Datenkommunikation nutzen. Zum Aufbau einer Kommunikation zwischen zwei Teilnehmern - Sender und Empfänger - wird dabei zunächst die Übertragungskapazität für die Datenkommunikation ermittelt. Dabei werden die Dämpfung und die Störungen mittels geeigneter Software analysiert und die Datenübertragung (z.B. Datenrate, Rahmenlänge, Modulationsverfahren, Kanalkodierung, etc.) entsprechend an die vorherrschenden Bedingungen angepasst.

Das erfindungsgemäße Verfahren nutzt die durch das PLC-System ermittelten Kanalinformationen zur Bestimmung der Niveaus und Charakteristika von Teilentladung, Wind- und Eislasten sowie Durchhang und Temperatur. Die vorhandenen PLC-Systeme werden dabei beispielsweise zusätzlich mit einer geeigneten Software und/oder Hardware ausgestattet, die mittels Zustandsschätzung (z.B. (Extended-)Kalman-Filter, Luenberger-Beobachter oder ähnlich) und auf Basis vorhandener Kanalinformationen die Zustandsparameter zu Teilentladungen, Durchhang, Temperatur und Windlasten schätzt. Die Daten werden hierzu idealerweise vom Digitalen Signalprozessor (DSP) oder einer anderen geeigneten Einrichtung des PLC-Systems übernommen.

In einer anderen Variante können die gewonnenen Kanalinformationen an eine zentrale Auswerteeinrichtung übermittelt werden. Diese kann beispielsweise einer Netzleitwarte zugeordnet sein. Die zentrale Auswerteeinrichtung kann in Software ausgebildet sein und z.B. als Cloud-Applikation betrieben werden.

Das erfindungsgemäße Verfahren bietet den Vorteil, dass keine zusätzliche Hardware benötigt wird. Es greift auf bereits vorhandene PLC-Systeme zurück. Aus bereits vorhandenen Informationen zur Datenübertragung werden Zustands-informationen bzw. Betriebszustände zu vorhandenen Betriebsmitteln gewonnen. Ein weiterer Vorteil ist es, dass das Verfahren sich sehr einfach als zusätzliche Software in bestehende PLC-Systeme integrieren lässt. Es ist folglich besonders einfach und kostengünstig und mit hohem Kundennutzen für bestehende Freileitungen nachrüstbar. Somit kann ein bestehendes Energieübertragungssystem um die Funktionalität der Zustandsüberwachung durch zusätzliche Software erweitert werden. Dies wird dadurch ermöglicht, dass anstatt einer direkten Messung der Zustandsparameter mit entsprechender zusätzlicher Messsensorik eine Schätzung mittels des erfindungsgemäßen Verfahrens erfolgt.

Energieversorgungsleitungen werden meist auch zur Kommunikation mit breitbandigen Signalen verwendet. Hierbei werden die Kommunikationssignale über kapazitive oder induktive Koppeleinrichtungen dem Energiesignal aufgeprägt. Um die Übertragungskapazität und die Datenübertragungskanaleigenschaften für die Datenkommunikation zu ermitteln, werden Testverfahren verwendet, die das Dämpfungs- und Störverhalten der Übertragungsleitung im Frequenzbereich des Kommunikationssystems bestimmen und so eine an die Kanaleigenschaften angepasste Datenkommunikation aufzubauen. Diese Parameter lassen auch Rückschlüsse auf den Betriebszustand von Übertragungsleitung zur Energieübertragung zu. So ändert sich beispielsweise bei zunehmendem Durchhang der Widerstand und die Phasenlage. Hochfrequente Störungen lassen auf Teilentladungen (TE) schließen, die durch Beschädigungen der Isolation oder durch andere isolationsdämpfende Ereignisse hervorgerufen werden.

Durch das erfindungsgemäße Verfahren kann auf zusätzliche Einrichtungen wie spezielle Teilentladungs-Sonden, Lichtwellenleiter oder andere Sensorik verzichtet werden. Es kann damit zu jedem Zeitpunkt und ohne weitere technische Hilfsmittel auf den Zustand geschlossen werden. Weiterhin können bestehende Systeme durch zusätzliche Software und ohne den Einsatz zusätzlicher Hardware nachgerüstet werden. Ein weiterer erfindungsgemäßer Vorteil ist, dass auf Basis historischer Daten auf das Alterungsverhalten geschlossen werden kann und z.B. die Belastung durch eine entsprechende Versorgungsnetzsteuerung angepasst werden kann.

Erfindungsgemäß umfassen die Parameter mindestens einen der Parameter Datenübertragungsrate, Bitfehlerrate, Signal-zu-Rauschen Verhältnis, Phasenlage, Rahmenlänge, Modulationsverfahren oder Kanalkodierung.

Außerdem wird der Zustand durch mindestens einen der Zustandsparameter Teilentladungsstatus, Durchhang einer Leitung, Schneelast und/oder Eislast auf der Leitung, Temperatur der Leitung, Windlast der Leitung angegeben angegeben.

Erfindungsgemäß werden bei der Datenkommunikation in einem empfangenen Signal Störungen erkannt, aus denen durch Tiefpassfilterung und Korrelation der Störungen mit der Phase und der maximalen Amplitude und/oder der Polarität des empfangenen Signals Teilentladungen erkannt werden.

In einer weiteren bevorzugten Ausführungsform des erfindungsgemäßen Verfahrens weist die Leitung zumindest teilweise eine Freileitung auf.

In einer weiteren bevorzugten Ausführungsform des erfindungsgemäßen Verfahrens erfolgt die Schätzung des Zustands mittels einer Rechnereinrichtung eines Senders und/oder Empfängers zur Datenkommunikation über eine elektrische Leitung. Beispielsweise kann hierfür eine bereits vorhandene Rechnereinrichtung wie der sog. digital signal processor verwendet werden, die mit einer zusätzlichen Softwarekomponente versehen wird.

In einer weiteren bevorzugten Ausführungsform des erfindungsgemäßen Verfahrens erfolgt die Schätzung des Zustands mittels einer zentralen Rechnereinrichtung. Beispielsweise kann hierfür eine Leitstelleneinrichtung zur Steuerung eines elektrischen Energieversorgungsnetzes, dessen Teil die elektrische Leitung ist, mit einer zusätzlichen Softwarekomponente versehen werden. Es kann auch eine Cloud-Anwendung zur Schätzung verwendet werden. In beiden Varianten ist es erforderlich, die Parameter für die Datenkommunikation an die zentrale Rechnereinrichtung zur Auswertung zu übertragen.

In einer weiteren bevorzugten Ausführungsform des erfindungsgemäßen Verfahrens werden Schwingungen von Leiterseilen anhand von periodischen Veränderungen der Teilentladungen festgestellt, wobei die Periodendauer von Schwingungen der Leiterseile und die Periodendauer der Veränderungen der Teilentladungen im Wesentlichen gleich lang ist. Dabei sind unter Leiterseilen beispielsweise die drei Phasen einer elektrischen Freileitung zu verstehen, deren Abstand sich bei windlastbedingten Schwingungen der Leiterseile periodisch verringert, was Teilentladungen begünstigt.

In einer weiteren bevorzugten Ausführungsform des erfindungsgemäßen Verfahrens wird bei der Zustandsschätzung eine Kanalübertragungsfunktion berücksichtigt, deren Amplitude und Phase bei der Datenübertragung durch die Zustandsparameter beeinflusst wird.

In einer weiteren bevorzugten Ausführungsform des erfindungsgemäßen Verfahrens wird bei der Zustandsschätzung ein Kalman-filter eingesetzt.

In einer weiteren bevorzugten Ausführungsform des erfindungsgemäßen Verfahrens wird bei der Zustandsschätzung ein Luenberger-Beobachter eingesetzt.

In einer weiteren bevorzugten Ausführungsform des erfindungsgemäßen Verfahrens wird bei der Zustandsschätzung anhand eines Laufzeitunterschieds bei Eintreffen von Störsignalen bei einem Empfänger und einem Sender die Position einer Störquelle bestimmt.

In einer weiteren bevorzugten Ausführungsform des erfindungsgemäßen Verfahrens wird bei der Zustandsschätzung anhand eines Leistungsdichteunterschieds bei Eintreffen von Störsignalen bei einem Empfänger und einem Sender die Position einer Störquelle bestimmt.

In einer weiteren bevorzugten Ausführungsform des erfindungsgemäßen Verfahrens wird bei der Zustandsschätzung anhand von Reflexionen eines zum Sender zurückgeworfenen Signals eine Längenänderung der Freileitung geschätzt.

Ferner stellt sich an die Erfindung die Aufgabe, eine Anordnung für eine Zustandsüberwachung von elektrischen Leitungen anzugeben, die besonders einfach und kostengünstig eingesetzt werden kann. Die Erfindung löst diese Aufgabe durch eine Anordnung gemäß Anspruch 14. Es ergeben sich sinngemäß die gleichen Vorteile wie eingangs für das erfindungsgemäße Verfahren erläutert.

Ferner stellt sich an die Erfindung die Aufgabe, ein Computerprogrammprodukt für eine Zustandsüberwachung von elektrischen Leitungen anzugeben, das besonders einfach und kostengünstig eingesetzt werden kann. Die Erfindung löst diese Aufgabe durch ein Computerprogrammprodukt gemäß Anspruch 15. Es ergeben sich sinngemäß die gleichen Vorteile wie eingangs für das erfindungsgemäße Verfahren erläutert.

Zur besseren Erläuterung der Erfindung zeigen in schematischer Darstellung die
- Figur 1: ein System zur Datenkommunikation über eine Freileitung, und
- Figur 2: ein mit Impulsstörsignalen überlagerte 50 Hz Spannung, und
- Figur 3: einen Störanteil für Teilentladungen, und
- Figur 4: einen Störanteil für periodische Impulsstörer, und
- Figur 5: einen Störanteil für zufällige Impulsstörer, und
- Figur 6: ein Gesamtstörsignal gemäß der Störungen der Figuren 3 bis 5, und
- Figur 7: einen zeitlichen Verlauf der Stromstärke eines Teilentladungsimpulses, und
- Figur 8: einen zeitlichen Verlauf der Frequenz dreier idealisierter Teilentladungsimpulse, und
- Figur 9: einen Prinzipaufbau eines Empfängers, und
- Figur 10: ein Prinzipaufbau eines Kalmanfilters, und
- Figur 11: eine Kreuzkorrelation Hochpass-gefilterter Störsignale, und
- Figur 12: eine Autokorrelation Hochpass-gefilterter Störsignale, und
- Figur 13: ein qualitativer Verlauf eines Signal-zu-Rauschen Verhältnisses und einer Datenübertragungsrate bei Eislast auf der Freileitung, und
- Figur 14: ein Reflexionsverlauf bei einer ersten Freileitungslänge, und
- Figur 15: eine Änderung des Reflexionsverlaufes nach Figur 14 bei gesteigerter Freileitungslänge.

Im Folgenden sollen nun die Details des erfindungsgemäßen Verfahrens anhand der Figuren beschrieben werden.

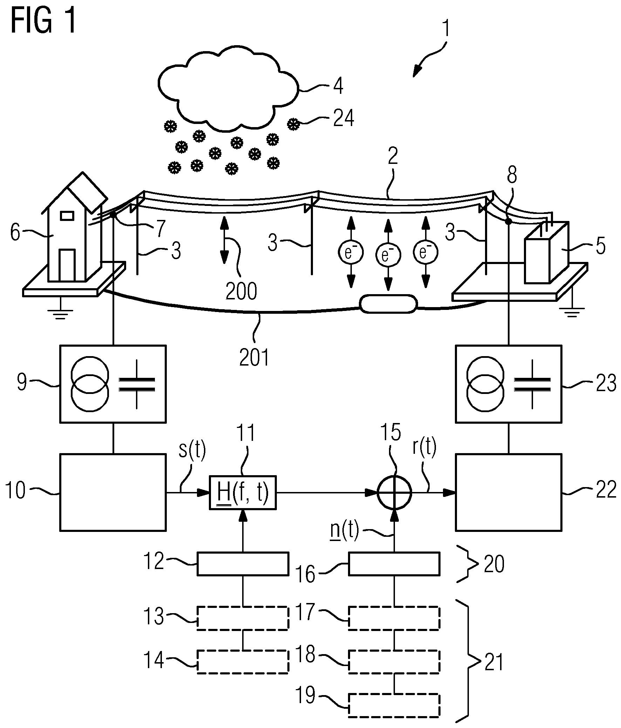

Die Figur 1 zeigt ein bekanntes System 1 zur Datenübertagung über Stromleitungen 2. Zwei Transformatorstationen 5,6 sind über eine dreiphasige Hochspannungsfreileitung 2 und über Erde 201 verbunden. Über der Freileitung 2 schneit es von einer Wolke 4 Schneeflocken 24 auf die Freileitung 2, die dadurch zwischen den Masten einen Durchhang 200 gegenüber ihrer Normallage erfährt. Der Schnee 4 bildet auf den Kabeln eine Schnee- oder Eislast aus.

Auf der linken Seite ist ein erster Einkoppelpunkt 7 mit einer ersten Koppeleinrichtung 9 verbunden. Auf der rechten Seite ist ein zweiter Einkoppelpunkt 8 mit einer zweiten Koppeleinrichtung 23 verbunden. Die Koppeleinrichtungen 8,23 dienen zur Ein- und Auskoppelung von Datensignalen in die Freileitung und sind damit sowohl Sender als auch Empfänger.

Zur Vereinfachung ist im Folgenden nur eine unidirektionale Kommunikation von links nach rechts dargestellt; tatsächlich findet eine Kommunikation in gleicher Weise jedoch auch von rechts nach links statt. Ein Sender 10 sendet ein Signal s(t) aus, das durch die Eigenschaften der Freileitung beeinflusst wird. Es ergibt sich eine Kanalübertragungsfunktion 11, hier mit H(f,t) bezeichnet, die durch Umwelteinflüsse 12, Dämpfung 13 und leitungsbedingte Tief-, Band-, oder Hochpassfilterung 14 beeinflusst wird. Die Kanalübertragungsfunktion 11 wird auch durch weitere Effekte in Amplitude und Phase beeinflusst. Diese sind z.B. ohmsche Verluste der charakteristischen Impedanz, Wärmeverluste, Durchhang, Eislasten, etc. (nicht dargestellt).

Zusätzlich sind dem Signal s(t) auch Störungen 15, mit n(t) bezeichnet, überlagert, die sich aus zustandsabhängigen Störungen 20 und systemisch vorhandenen Störungen 21 zusammensetzen. Zu den zustandsabhängigen Störungen 20 zählen Teilentladungen 16, die im Bild durch Elektronen e- angedeutet sind. Zu den systemisch vorhandenen Störungen 21 gehören Impulsstörer 17 (z.B. Schaltvorgänge in elektrischen Anlagen, Bürstenfeuer von Elektromotoren), Hintergrundrauschen 18 sowie Schmalbandstörer 19 (z.B. von Radiosendern verursacht). Es ergibt sich schlussendlich aus dem Signal s(t) das gestörte Signal r(t), das bei der zweiten Koppeleinrichtung 22 empfangen wird.

Das erfindungsgemäße Verfahren dient dazu, diejenigen Dämpfungseffekte und Störungen für die Ermittlung des Betriebszustands der Freileitung auszuwerten, die durch zustandsabhängige Effekte verursacht werden. Wie eingangs erläutert sind dies Umwelteinflüsse und Teilentladungen. Diese werden durch das erfindungsgemäße Schätzverfahren aus der Summe der Beeinflussungen extrahiert und quantifiziert.

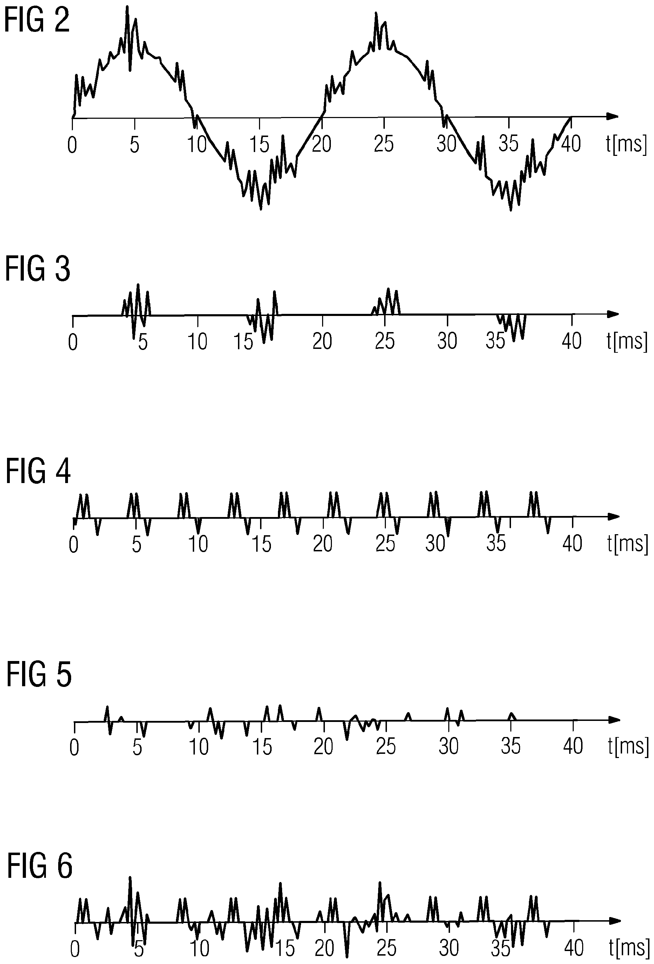

Anhand der Figuren 2 bis 6 werden die Störungen näher beschrieben; sie zeigen die Simulation eines 50 Hz Energiesignals mit Teilentladungen und überlagerten Impulsstörern im Zeitbereich.

Teilentladungen entstehen durch "Fehler" in der Isolation und korrespondieren bei Wechselstromanlagen mit den Maxima des Spannungsverlaufs. Im Zeitbereich zeigen sich Teilentladungen als Impulsstörer die dem Spannungssignal additiv überlagert sind. Figur 2 zeigt eine mit Impulsstörsignalen überlagerte 50 Hz Spannung, und Figur 3 einen Störanteil für Teilentladungen. Figur 4 zeigt einen Störanteil für periodische Impulsstörer, und Figur 5 einen Störanteil für zufällige Impulsstörer. Figur 6 schließlich zeigt ein Gesamtstörsignal gemäß der Störungen der Figuren 3 bis 5.

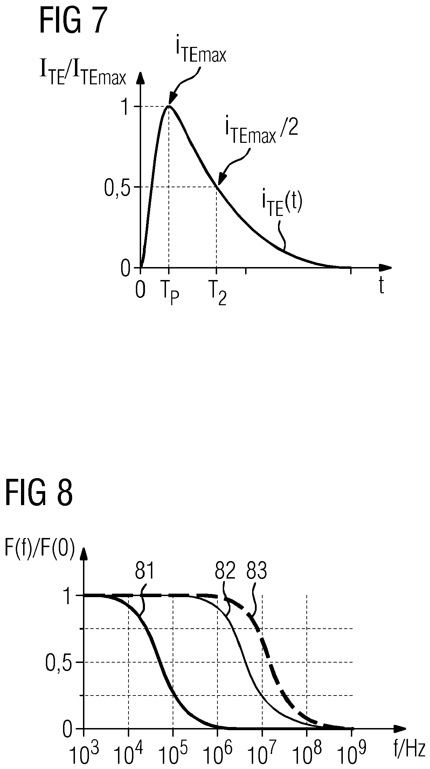

Figur 7 zeigt beispielhaft einen zeitlichen Verlauf der Stromstärke eines Teilentladungsimpulses, und Figur 8 bildet einen zeitlichen Verlauf der Frequenz dreier Teilentladungsimpulse 81,82,83 ab.

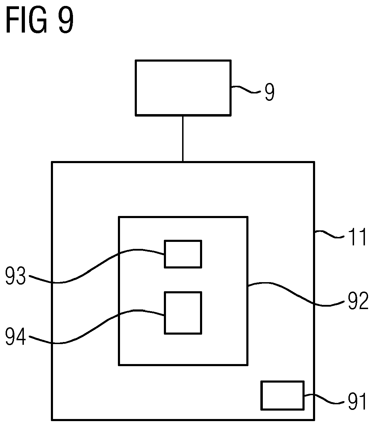

Figur 9 zeigt einen Prinzipaufbau eines Empfängers 10, wobei der gleiche Aufbau auch für einen Sender verwendet werden kann. Das Gerät weist eine Kommunikationsverbindung zu einer Koppeleinrichtung 9 auf. Weiterhin sind eine Energieversorgung 91 und eine Datenverarbeitungseinrichtung 92 vorgesehen, die i.d.R. als sog. Digital Signal Processor (DSP) ausgebildet ist. Die Datenverarbeitungseinrichtung 92 ist dafür ausgebildet, einerseits als Datenpumpe 94 für die über die Freileitung zu übermittelnden Daten und andererseits als Zustandsüberwachungseinrichtung 93 zu fungieren. Datenpumpe 92 und Zustandsüberwachungseinrichtung 93 können komplett als Software ausgebildet sein. In einer alternativen Ausgestaltung kann eine separate Hardware wie z.B. ein Mirkoprozessor mit Datenspeicher als Zustandsüberwachungseinrichtung 93 eingesetzt werden. Die Zustandsüberwachungseinrichtung 93 ist dafür ausgebildet, aus den für die Datenkommunikation bestimmten Parametern einen Zustand der elektrischen Freileitung zu schätzen.

Sender und Empfänger für Powerline Communication enthalten i.d.R. bereits einen geeigneten Tiefpassfilter, um aus einem empfangenen Energiesignal (Figur 2) die Summe der Störungen (Figur 6) inklusive der Teilentladungen (Figur 3) herauszufiltern. Hintergrundrauschen und Schmalbandstörer werden in den Figuren 2 bis 2 zugunsten einer besseren Verständlichkeit vernachlässigt.

Prinzipiell handelt es sich bei Teilentladungen dem Charakter nach ebenfalls um periodische Impulsstörer, die jedoch einen klaren Phasenbezug zu den Maxima des Energiesignals haben und die ab einer bestimmten Spannung, der Teilentladungs-Einsetzspannung, auftreten. Ferner korrelieren diese meist mit der Polarität des Energiesignals. Diese Charakteristik wird dazu verwendet um aus dem Störszenario (Figur 6) die jenigen zu identifizieren die den Phasen- und Spannungsbezug aufweisen. Ein entsprechender Zustandsbeobachter wird dahingehend parametriert, wobei die Parametrierung auf empirischen Messungen bekannter Teilentladungs-Quellen basiert.

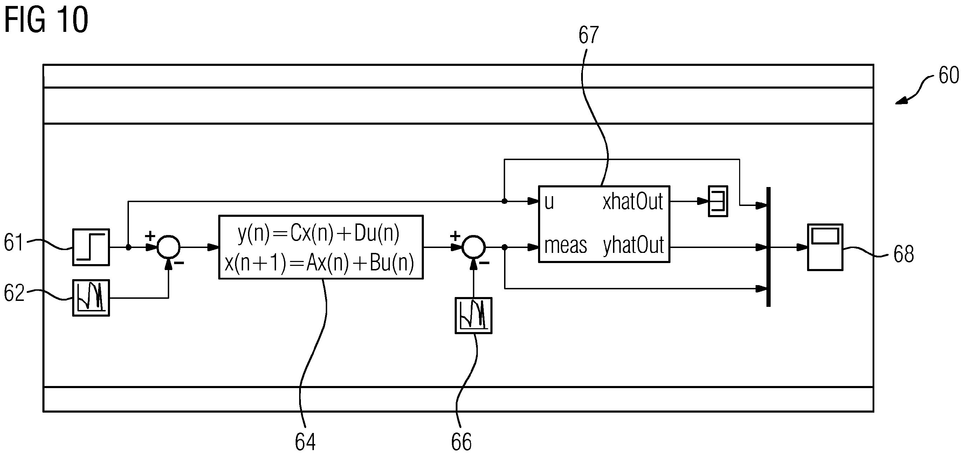

Ein prinzipieller Aufbau eines Filters bzw. Zustandsbeobachters ist in Figur 10 dargestellt. Es handelt sich um ein Prinzipschaltbild 60, das mittels der Software SimuLink erstellt wurde. Eingangsdaten 61 und Rauschsignale 62 werden in einem Modell 64 vorverarbeitet und anschließend unter Berücksichtigung von Messrauschen 66 einem Kalman-Filter zur Verfügung gestellt. Das Endergebnis 68 wird bereits gestellt.

Empirische Messungen von Teilentladungen sind zur Parametrierung für Schaltanlagen bereits vorhanden, für Freileitungen und Kabel können diese leicht gemessen werden. Da ein physikalisch idealer Impuls sich im Frequenzspektrum als konstante Funktion in Abhängigkeit seiner Leistungsdichte zeigt und selbst nicht ideale Impulsstörungen sehr breitbandig sind (Figuren 7 und 8), stellen Filter zunächst keine Hürde für die Detektion von Impulsstörern mit PLC-Systemen dar. Mehr noch, diese Eigenschaft kann zur Ortsbestimmung der Teilentladungs-verursachenden Fehlstelle herangezogen werden.

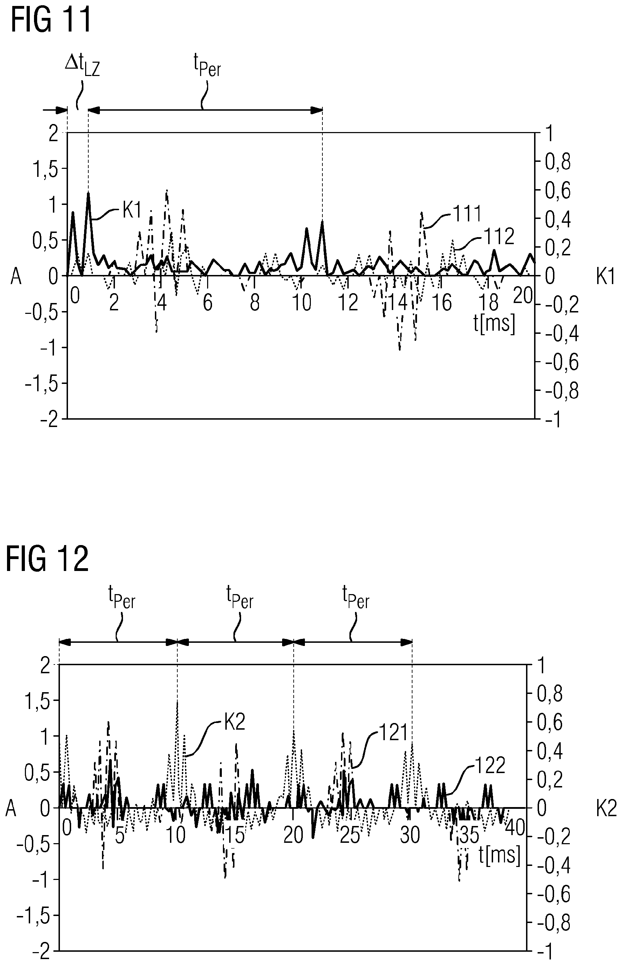

Zwei an der Kommunikation beteiligte PLC-Systeme empfangen prinzipiell im Wesentlichen die gleichen Impulsstörungen, die zwischen den beiden Kommunikationssystemen auftreten. Ein Unterschied liegt jedoch zum Einen in der Laufzeitdifferenz der Signale und zum Anderen in der unterschiedlichen Leistungsdichte der Impulsstörung (Figuren 11 und 12). Die Laufzeitdifferenz kann dabei durch die zeitliche Verschiebung der Empfangssignale zweier PLC-System ermittelt werden.

Die Figur 11 zeigt die zeitabhängige Amplitude A zweier empfangener Signale 111,112. Die beiden empfangenen Signale werden bei zwei unterschiedlichen Geräten für PLC detektiert (jeweils Sender und Empfänger kombiniert, so dass eine bidirektionale Kommunikation möglich ist). Es ergibt sich eine Laufzeitdifferenz der Signale von Δt_{LZ}. Eine Kreuzkorrelationsfunktion K1 zwischen den Signalen 111,112 weist gemäß der für K1 rechts dargestellten Achse hohe Korrelationswerte bei ca. 1ms und 11ms auf, woraus sich aus dem Abstand der Nebenmaxima zum Hauptmaximum und zueinander eine Periodenzeit für die Teilentladung t_{Per} von ca. 10 ms ergibt. Aus dem Signal der Gesamtstörungen gemäß Figur 6 kann auf diese Weise eine Verschiebung des Hauptmaximums vom Nullpunkt Δt_{LZ} von beispielsweise 0,9ms im hier dargestellten Fall erkannt werden.

Die Figur 12 zeigt in ähnlicher Weise eine Autokorrelationsfunktion K2 zwischen den Signalen 121,122. Sie kann zur Identifikation der Periodizität, d.h. dem Zusammenhang zur Phase des Energiesignals, noch eine deutlich genauere Informationen t_{Per} liefern.

Zusätzlich liefert die Differenz der Leistungsdichte einen weiteren Parameter zum Ort der Entstehung der Teilentladung. Die Impulsantwort des Übertragungskanals liefert hierzu die Übertragungsfunktion H(f,t), entsprechend derer die Leistungsdichte der Teilentladungs-Signale gedämpft wird. Üblicherweise wird beim Aufbau einer Kommunikation die Impulsantwort des PLC-Kanals bestimmt und ist somit bekannt.

Mit der Impulsantwort werden auch die Impulsstörer gedämpft. Da die Dämpfung ebenfalls ortsabhängig ist, erhalten zwei Kommunikationssysteme dasselbe Teilentladungs-Signal, jedoch mit unterschiedlicher Leistungsdichte. Aus der Differenz der Leistungsdichte kann folglich ebenfalls auf den Ort der Entstehungsstelle der Teilentladung geschlossen werden, dies kann wiederum mit einem geeigneten Zustandsschätzer umgesetzt werden. Die Parametrierung des Zustandsbeobachters kann hierbei mit der Information aus der Impulsantwort bzw. Kanalschätzung erfolgen.

Im Folgenden sollen nun neben den bereits erörterten Teilentladungen auch andere Störquellen untersucht werden.

Durch Wind angeregte Schwingungen von Leiterseilen führen zu zeitabhängigen Reduzierungen der Abstände einzelner Leiterseile zueinander (vgl. hierzu Dreyer, Oliver; Regen-Wind induzierte Seilschwingungen in laminarer und turbulenter Strömung, Dissertation 2004 am Institut für Stahlbau der TU Braunschweig). Hierbei schwingen die Leiterseile mit Frequenzen bis zu 4 Hz und einer Auslenkung von bis zu 60cm aus. Diese Schwingungen führen bei stromdurchflossenen Leitern zu Änderungen des elektrischen Feldes und der Isolationsabstände. Diese wiederum führen zu Änderungen des Stroms und der Teilentladungscharakteristik. Nimmt z.B. der Abstand der Leiterseile ab, so erhöht sich die Feldstärke und Teilentladungen nehmen zu. Die durch Windlasten verursachte Teilentladungen korrelieren mit der Schwingfrequenz der Leiterseile mit einer Periodizität entsprechend der Schwingungsfrequenz (< 4Hz). Die Auswertung und Detektion erfolgt entsprechend der bereits erläuterten Feststellung von Teilentladungen.

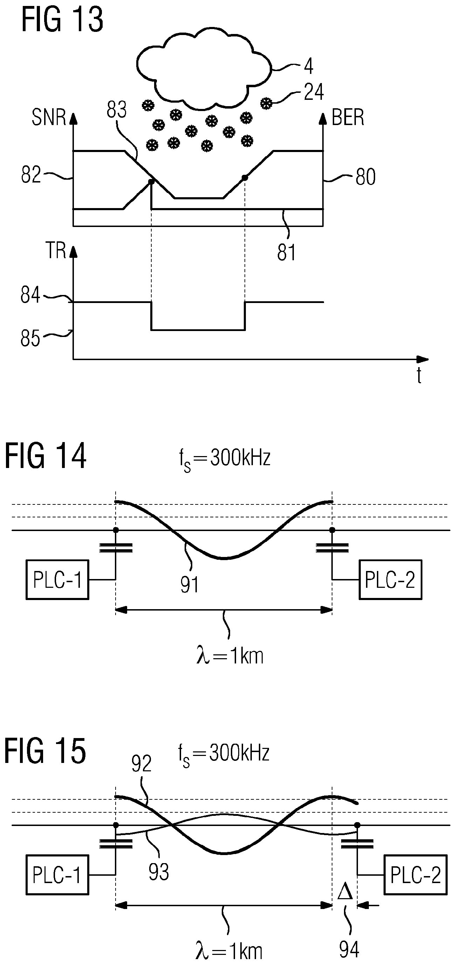

Auch ein Durchhang und eine Betriebsmitteltemperatur von Freileitungen können auf Basis der ermittelten Parameter der komplexen Kanalübertragungsfunktion geschätzt werden. Dabei hängt der Durchhang stark von der aktuellen Leitertemperatur und der durch Eis, Schnee und auch Wind verursachten Lasten ab. Weiterhin haben Schnee- und Eislasten eine Reduzierung der Übertragungskanalkapazität zur Folge, was sich in einer Reduzierung des SNR (Signal-to-Noise-Ratio) und in einer Erhöhung der Blockfehlerrate (BER) der PLC-Übertragung zeigt. Die Figur 13 zeigt diesen Zusammenhang schematisch auf. Es ist das Signal-zu-Rauschen Verhältnis (SNR) auf der Achse 82 nach der Zeit aufgetragen. Werden von einer Wolke 4 für eine gewisse Zeit Eiskristalle 24 abgegeben, die sich auf der Leistung als Eislast niederschlagen, so verschlechtert sich das Signal-zu-Rauschen Verhältnis 83 während der dieser Zeit merklich. Die Bitfehlerrate BER, die auf der Achse 80 mit dem Verlauf 81 dargestellt ist, steigt zu Beginn des Eisbefalls leicht an und erreicht anschließend wieder ihr Ausgangsniveau.

Auch die im unteren Teil der Figur 13 dargestellte Übertragungsrate des PLC-Systems sinkt infolge der Eislast auf der Leitung von der primären Übertragungsrate 84 zur sekundären Übertragungsrate 85 ab. Um eine sichere Übertragung der PLC-Systeme zu gewährleisten, wird die Übertragungsrate jeweils an die vorherrschenden Bedingungen angepasst, also im Beispiel auf die sekundäre Übertragungsrate 85 erniedrigt.

Zusätzlich liefern bekannte Parameter wie aktuelle Umgebungstemperatur, Sonneneinstrahlung und Strombelastung hilfreiche Informationen, um die Schätzung qualitativ zu verbessern; zu diesem Zweck werden diese beim Zustandsbeobachter mitberücksichtigt - eine entsprechende Schätzmatrix kann um diese Parameter erweitert werden.

Bei Freileitungen korreliert der irreversible Teil des Durchhangs der Leitung mit dem Alterungszustand der Freileitung: je höher die durchschnittliche Temperaturbelastung, desto größer ist der Alterungszustand der Freileitung (vgl. hierzu "Alterung von Freileitungen"; Michael Muhr, Robert Schwarz, Stefan Jaufer; Institut für Hochspannungstechnik und Systemmanagement, Technische Universität Graz). Dabei korrespondieren die Längenzunahmen der Freileitung (zur Berechnung vgl. "Eine Fallstudie zu Freileitungen", IT Nachrichten 2/12; Michael Roser, Hans Rudolf Schneebeli) mit der Phasenlage des PLC-Signals. Bei Datenübertragungssystemen wird stets versucht, das Kommunikationssystem an den Wellenwiderstand der Übertragungsleitung (hier die Freileitung) anzupassen, um Reflektionen und Signalverluste zu vermeiden. Ziel ist es, beim Empfänger eine Reflexion des Datensignals zu vermeiden, indem der Empfänger optimal an den Wellenwiderstand der Freileitung angepasst ist. Bei Freileitungen wiederum hängt der Wellenwiderstand auch von der Länge der Leitung ab, welcher sich bei einer Längenänderung ebenfalls ändert. Die Wellenlängen der Trägersignale der PLC-Systeme sind jeweils konstant. Dieser Zusammenhang ist in den Figuren 14 und 15 dargestellt.

Es ergibt sich in Figur 14 beispielswweise bei einer typischen Signalfrequenz von 300 kHz für das Signal 91 eine Wellenlänge von rund 1 km. Zwei PLC-Systeme, die in einem Abstand von 1 km kommunizieren, seien dabei ideal angepasst: es kommt zu keinen Reflexionen bei der Datenübertragung.

Nimmt nun wie in Figur 15 die Länge durch eine Zunahme des Durchhangs zu, so sind die PLC-Systeme nicht mehr an den Wellenwiderstand angepasst. Es entstehen für das Signal 92 Reflexionen 93 und es kommt zu Phasenverschiebungen, die ein Maß für die Längenänderung 94 sind. Dabei werden beispielsweise beim Senden von Trainigssequenzen zu Beginn einer Datenkommuniktion gleichzeitig mit dem Empfangsmodul des Senders die entstehenden Reflexionen (Echos) detektiert. Anschließend wird mittels eines geeigneten Zustandsschätzers das Niveau der Reflexion bestimmt und so ein Maß für die Längenänderung 94 ermittelt. Unter Berücksichigung des Mastabstands und vorherschender Umweltparameter wie etwa der Temperatur kann der Durchhang rechnerisch geschätzt werden.

## Patentansprüche

1. Verfahren für eine Zustandsüberwachung einer elektrischen Leitung, bei dem
eine Datenkommunikation über die elektrische Leitung betrieben wird, wobei Parameter für die Datenkommunikation bestimmt werden, und
aus den Parametern ein Zustand der elektrischen Leitung geschätzt wird, wobei
die Parameter mindestens einen der Parameter Datenübertragungsrate, Bitfehlerrate, Signal-zu-Rauschen Verhältnis, Phasenlage, Rahmenlänge, Modulationsverfahren oder Kanalkodierung umfassen,
**dadurch gekennzeichnet, dass**
der Zustand durch mindestens einen der Zustandsparameter Teilentladungsstatus, Durchhang einer Leitung, Schneelast und/oder Eislast auf der Leitung, Temperatur der Leitung, Windlast der Leitung angegeben wird, wobei
bei der Datenkommunikation in einem empfangenen Signal Störungen erkannt werden, aus denen durch Tiefpassfilterung und Korrelation der Störungen mit der Phase und der maximalen Amplitude und/oder der Polarität des empfangenen Signals Teilentladungen erkannt werden.

2. Verfahren nach Anspruch 1, **dadurch gekennzeichnet, dass** Schwingungen von Leiterseilen anhand von periodischen Veränderungen der Teilentladungen festgestellt werden, wobei die Periodendauer von Schwingungen der Leiterseile und die Periodendauer der Veränderungen der Teilentladungen im Wesentlichen gleich lang ist.

3. Verfahren nach Anspruch 1 oder 2, **dadurch gekennzeichnet, dass** die Leitung zumindest teilweise eine Freileitung aufweist.

4. Verfahren nach einem der vorhergehenden Ansprüche, **dadurch gekennzeichnet, dass** die Schätzung des Zustands mittels einer Rechnereinrichtung des Senders und/oder Empfängers erfolgt.

5. Verfahren nach einem der vorhergehenden Ansprüche, **dadurch gekennzeichnet, dass** bei der Zustandsschätzung eine Kanalübertragungsfunktion berücksichtigt wird, deren Amplitude und Phase bei der Datenübertragung durch die Zustandsparameter beeinflusst wird.

6. Verfahren nach einem der vorhergehenden Ansprüche, **dadurch gekennzeichnet, dass** bei der Zustandsschätzung ein Kalmanfilter eingesetzt wird.

7. Verfahren nach einem der vorhergehenden Ansprüche, **dadurch gekennzeichnet, dass** bei der Zustandsschätzung ein Luenberger-Beobachter eingesetzt wird.

8. Verfahren nach einem der vorhergehenden Ansprüche, **dadurch gekennzeichnet, dass** bei der Zustandsschätzung anhand eines Laufzeitunterschieds bei Eintreffen von Störsignalen bei Empfänger und Sender die Position einer Störquelle bestimmt wird.

9. Verfahren nach einem der vorhergehenden Ansprüche, **dadurch gekennzeichnet, dass** bei der Zustandsschätzung anhand eines Leistungsdichteunterschieds bei Eintreffen von Störsignalen bei Empfänger und Sender die Position einer Störquelle bestimmt wird.

10. Verfahren nach einem der vorhergehenden Ansprüche, **dadurch gekennzeichnet, dass** bei der Zustandsschätzung anhand von Reflexionen eines zum Sender zurückgeworfenen Signals eine Längenänderung der Freileitung geschätzt wird.

11. Anordnung für eine Zustandsüberwachung einer elektrischen Leitung, aufweisend einen Sender und einen Empfänger, die für eine Datenkommunikation über eine elektrische Leitung ausgebildet sind,
**dadurch gekennzeichnet, dass**
der Sender und/oder der Empfänger dafür ausgebildet sind, ein Verfahren nach einem der Ansprüche 1 bis 10 auszuführen.

12. Computerprogrammprodukt, das zur Ausführung auf einem Sender und/oder einem Empfänger einer Anordnung gemäß Anspruch 11 vorgesehen ist, **dadurch gekennzeichnet, dass** das Computerprogrammprodukt einen Programmcode aufweist, der bei Ausführung ein Verfahren gemäß einem der Ansprüche 1 bis 10 durchführt.

## Claims

1. Method for monitoring a state of an electrical line, in which a data communication is carried out over the electrical line, wherein parameters for the data communication are determined, and a state of the electrical line is estimated from the parameters, wherein the parameters comprise at least one of the parameters of data transmission rate, bit error rate, signal-to-noise ratio, phase angle, frame length, modulation method and channel encoding,
**characterized in that**
the state is indicated by at least one of the state parameters of partial discharge status, sag of a line, snow loading and/or ice loading on the line, temperature of the line, wind loading of the line, wherein disturbances are recognized in a received signal during data communication, from which partial discharges are recognized through low-pass filtering and correlation of the disturbances with the phase and the maximum amplitude and/or the polarity of the received signal.

2. Method according to Claim 1, **characterized in that** oscillations of conductor cables are ascertained on the basis of periodic changes to the partial discharges, wherein the period duration of oscillations of the conductor cables and the period duration of the changes of the partial discharges are of essentially equal length.

3. Method according to Claim 1 or 2, **characterized in that** the line at least partially comprises an overhead line.

4. Method according to one of the preceding claims, **characterized in that** the estimation of the state is performed by means of a computer apparatus of the transmitter and/or receiver.

5. Method according to one of the preceding claims, **characterized in that** a channel transfer function, the amplitude and phase of which during the data transfer is influenced by the state parameters, is taken into account in the state estimation.

6. Method according to one of the preceding claims, **characterized in that** a Kalman filter is used in the state estimation.

7. Method according to one of the preceding claims, **characterized in that** a Luenberger observer is used in the state estimation.

8. Method according to one of the preceding claims, **characterized in that** the position of a source of disturbance is determined during the state estimation on the basis of a transit-time difference upon the arrival of disturbing signals at the receiver and transmitter.

9. Method according to one of the preceding claims, **characterized in that** the position of a source of disturbance is determined during the state estimation on the basis of a power density difference upon the arrival of disturbing signals at the receiver and transmitter.

10. Method according to one of the preceding claims, **characterized in that** a change in the length of the overhead line is estimated during the state estimation on the basis of reflections of a signal bounced back to the transmitter.

11. Arrangement for monitoring the state of an electrical line, comprising a transmitter and a receiver that are designed for a data communication over an electrical line,
**characterized in that**
the transmitter and/or the receiver are designed to execute a method according to one of Claims 1 to 10.

12. Computer program product that is provided for execution at a transmitter and/or a receiver of an arrangement according to Claim 11, **characterized in that** the computer program product comprises a program code that carries out a method according to one of Claims 1 to 10 when executed.

## Revendications

1. Procédé de contrôle de l'état d'une ligne électrique, dans lequel on fait fonctionner une communication de données par la ligne électrique,
dans lequel on définit des paramètres pour la communication de données, et
on estime un état de la ligne électrique à partir des paramètres, dans lequel
les paramètres comprennent au moins l'un des paramètres, taux de transmission des données, taux d'erreur de bit, rapport signal à bruit, position en phase, longueur de trame, procédé de modulation ou codage de canal,
**caractérisé en ce que**
on indique l'état par au moins l'un des paramètres d'état, statut de décharge partiel, fléchissement d'une ligne, charge de neige et/ou charge de glace sur la ligne, température de la ligne, effet du vent sur la ligne, dans lequel,
lors de la communication de données, on reconnaît des perturbations dans un signal reçu, à partir desquelles on reconnaît, par filtrage passe-bas et corrélation des perturbations à la phase et à l'amplitude maximum et/ou à la polarité du signal reçu, des décharges partielles.

2. Procédé suivant la revendication 1, **caractérisé en ce que** l'on constate des oscillations de câbles conducteurs à l'aide de variations périodiques des décharges partielles, la durée d'oscillation des câbles conducteurs et la durée des variations des décharges partielles ayant sensiblement la même longueur.

3. Procédé suivant la revendication 1 ou 2, **caractérisé en ce que** la ligne a au moins en partie une ligne aérienne.

4. Procédé suivant l'une des revendications précédentes, **caractérisé en ce que** l'estimation de l'état s'effectue au moyen d'un dispositif informatique de l'émetteur et/ou du récepteur.

5. Procédé suivant l'une des revendications précédentes, **caractérisé en ce que**, pour l'estimation de l'état, on prend en compte une fonction de transfert de canal, dont l'amplitude et la phase sont, lors de la transmission de données, influencées par le paramètre d'état.

6. Procédé suivant l'une des revendications précédentes, **caractérisé en ce que** l'on utilise un filtre Kalman pour l'estimation d'état.

7. Procédé suivant l'une des revendications précédentes, **caractérisé en ce que** l'on utilise un observateur Luenberger pour l'estimation d'état.

8. Procédé suivant l'une des revendications précédentes, **caractérisé en ce que**, pour l'estimation d'état, on détermine la position d'une source de perturbation, à l'aide d'une différence de temps de parcours à l'arrivée de signaux perturbateurs au récepteur et à l'émetteur.

9. Procédé suivant l'une des revendications précédentes, **caractérisé en ce que**, pour l'estimation d'état, on détermine une source de perturbation, à l'aide d'une différence de densité de puissance à l'arrivée de signal perturbateurs au récepteur et à l'émetteur.

10. Procédé suivant l'une des revendications précédentes, **caractérisé en ce que**, pour l'estimation d'état, on estime une variation de longueur de la ligne aérienne, à l'aide de réflexion d'un signal renvoyé à l'émetteur.

11. Equipement de contrôle de l'état d'une ligne électrique, comportant un émetteur et un récepteur, qui sont constitués pour une communication de données par une ligne électrique,
**caractérisé en ce que**
l'émetteur et/ou le récepteur sont constitués pour effectuer un procédé suivant l'une des revendications 1 à 10.

12. Produit de programme d'ordinateur, qui est prévu pour être exécuté sur un émetteur et/ou un récepteur d'un équipement suivant la revendication 11, **caractérisé en ce que** le produit de programme d'ordinateur a un code de programme, qui, lorsqu'il est exécuté, effectue un procédé suivant l'une des revendications 1 à 10.
